# EUROPEAN PATENT SPECIFICATION

(11) **EP 4 394 414 B1**
(45) Date of publication and mention of the grant of the patent: **02.09.2026**
(21) Application number: 23839971.1
(22) Date of filing: 12.07.2023
(51) Int. Cl.: G01R 31/392, G01R 31/367, G01R 31/3835, G01R 19/165, G01R 19/30, B60L 58/16, B60L 3/00, B60L 3/12, B60L 58/22, H01M 10/42, G01R 31/3842, G01R 31/396

(54) **BATTERY MANAGEMENT DEVICE AND METHOD**
BATTERIEVERWALTUNGSVORRICHTUNG UND -VERFAHREN
DISPOSITIF ET PROCÉDÉ DE GESTION DE BATTERIE

(30) Priority: 15.07.2022 KR 20220087606
(43) Date of publication of application: 03.07.2024
(73) Proprietor: LG Energy Solution, Ltd., Seoul 07335 (KR)
(72) Inventor: KIM, Jun Yeong, Daejeon 34122 (KR); KIM, Dong Hyun, Daejeon 34122 (KR)
(74) Representative: Plasseraud IP
(86) International application number: PCT/KR2023/009970
(87) International publication number: WO 2024/014880

(56) References cited:
- KR-A- 20160 086 738
- KR-A- 20170 134 187
- KR-A- 20190 010 004
- KR-A- 20190 037 882
- KR-A- 20210 051 461
- US-A1- 2017 343 614
- US-A1- 2019 036 357
- US-A1- 2020 044 459
- US-A1- 2021 021 144

## Description

### TECHNICAL FIELD

The present invention relates to a battery management system, and more particularly, to a battery management system and method capable of preventing a faulty diagnosis due to measurement errors of a battery monitoring integrated circuit (BMIC) and a main control unit (MCU) of the battery management system. Furthermore, in applying an overvoltage detection integrated circuit (IC) to prevent the faulty diagnosis, there is a case where an error occurs in the diagnosis by a conventional overvoltage detection IC. The present invention relates to the battery management system and method of preventing the diagnosis error of the conventional overvoltage detection IC.

### BACKGROUND ART

A secondary battery capable of charging and discharging, that is, a battery, is widely used as an energy source for mobile devices such as smart phones. In addition, the battery is used as an energy source for eco-friendly vehicles such as an electric vehicle and a hybrid electric vehicle proposed as a solution to air pollution caused by a gasoline vehicle and a diesel vehicle using fossil fuels. The types of applications using the battery are becoming very diverse, and it is expected that the battery will be applied to more fields and products than now in the future.

Currently commercialized available batteries include a nickel cadmium battery, a nickel hydrogen battery, a nickel zinc battery, and a lithium ion battery. Among these batteries, the lithium ion battery is spotlighted due to their advantages of free charge and discharge, very low self-discharge rate, and high energy density because the memory effect hardly occurs compared to the nickel-based battery. In addition, since the lithium ion battery can be manufactured in a small size, the lithium ion battery is used as a power source for mobile devices, and the use range thereof has been expanded as a power source for the electric vehicle, thereby drawing attention as a next-generation energy storage medium.

An electrical and electronic device that uses the battery as power should be equipped with a battery management system (BMS), etc. in order to control the operation of the battery. The BMS may monitor states of the battery, such as temperature, voltage, and current, and may control battery balancing, charging or discharging through state of charge (SOC) estimation, etc. based on the monitored battery state. Such a BMS may include a battery monitoring IC (BMIC) for monitoring the state of the battery and generating a diagnosis signal and a main control unit(MCU) for controlling the battery according to the state of the battery. In this case, the BMIC and the MCU are connected through a predetermined communication line to input/output data or a signal. That is, the BMIC generates the diagnosis signal from state information such as voltage, current, and temperature measured for the battery and transmits the diagnosis signal to the MCU. In addition, the MCU may receive the diagnosis signal from the BMIC, determine the state of the battery, and control the battery according to a determination result according to the state of the battery.

Meanwhile, the battery management system may not be able to diagnose an over voltage, for example, of the battery due to a measurement error of the MCU or BMIC. In this situation, an overvoltage detection unit is provided in order to maintain the battery in a safety state. The overvoltage detection unit receives a voltage monitoring result of the battery and detects whether a battery voltage is the overvoltage exceeding a set voltage. In this case, one overvoltage detection unit may be provided in the battery management system. That is, conventionally, one overvoltage detection unit is provided in the BMS to detect whether the voltage monitoring result of the battery is the overvoltage exceeding the set voltage, and to maintain the battery in the safe state through the MCU.

However, according to the prior art of determining the overvoltage using one overvoltage detection unit, a problem of erroneous detection may occur due to a failure of the overvoltage detection unit or a failure of a peripheral circuit around the overvoltage detection unit. That is, a problem in which the overvoltage detection unit does not properly detect the overvoltage may occur due to the failure of the overvoltage detection unit itself or the failure of the peripheral circuit around the overvoltage detection unit. If the overvoltage is not properly detected due to the failure of one overvoltage detection unit, a problem in which the battery is not controlled and thus the battery cannot be used, etc. may occur.

Document US 2021/021144 discloses a battery pack detachably connectable to an electric tool or a charger and including a housing, a cell group, a first voltage monitoring module, a control module, a second voltage monitoring module and a protection module according to the related art.

Related prior art includes the following documents.
Patent document 1: KR 10-2021-0049470 A (2021. 5. 6.)
Patent document 2: JP 2011-002350 A (2011. 1. 6)
Patent document 3: KR 2008-0021255 A (2008. 3. 7)

### DISCLOSURE OF THE INVENTION

### TECHNICAL PROBLEM

The present invention provides a battery management system and method capable of preventing erroneous detection by an overvoltage detection unit.

The present invention provides a battery management system and method capable of preventing erroneous detection of overvoltage by detecting a battery voltage by being provided with at least two overvoltage detection units having different reference voltages.

### TECHNICAL SOLUTION

A battery management method according to the present invention is defined in the appended claims.

### ADVANTAGEOUS EFFECTS

The battery management system according to an embodiment of the present invention includes the first and second overvoltage detection units having different first and second reference voltages between the BMIC and then MCU. -The first and second overvoltage detection units compare the measured voltage of the battery with the first and second reference voltages, respectively, and output first and second detection signals to the MCU, respectively. The MCU may diagnose abnormalities of the BMIC, the first and second overvoltage detection units, and a peripheral circuit thereof using the first and second detection signals. That is, when the second detection signal is generated, the MCU may diagnose a measurement error of the BMIC or MCU by comparing the voltage of the battery input from the BMIC with the second reference voltage. In addition, when the second detection signal is generated, the MCU may diagnose an error of at least one of the first and second overvoltage detection units according to whether or not the first detection signal is generated.

Therefore, compared to the prior art, the present invention can prevent an erroneous detection problem due to a failure of the overvoltage detection unit or a failure of a peripheral circuit around the overvoltage detection unit. -That is, by using two overvoltage detection units having different reference voltages, a problem in which the overvoltage detection unit does not properly detect overvoltage due to a failure of the overvoltage detection unit itself or a failure of the peripheral circuit around the overvoltage detection unit can be prevented.

### BRIEF DESCRIPTION OF THE DRAWINGS

FIG. 1 is a block diagram for illustrating a configuration of a battery management system according to an embodiment of the present invention.
FIG. 2 is a block diagram for illustrating a configuration of an MCU of the battery management system according to an embodiment of the present invention.
FIG. 3 is a flowchart illustrating a method of driving the battery management system according to an embodiment of the present invention.

### MODE FOR CARRYING OUT THE INVENTION

Hereinafter, embodiments of the present invention will be described in detail with reference to the accompanying drawings. However, the present invention will not be limited to the embodiments disclosed below, but will be implemented in a variety of different forms, and only these embodiments are provided to complete the disclosure of the present invention and to fully inform those skilled in the art of the scope of the invention.

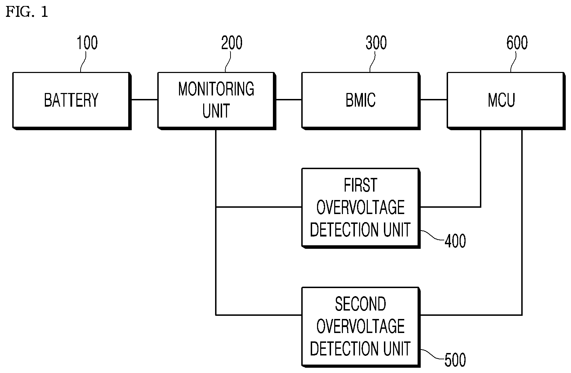

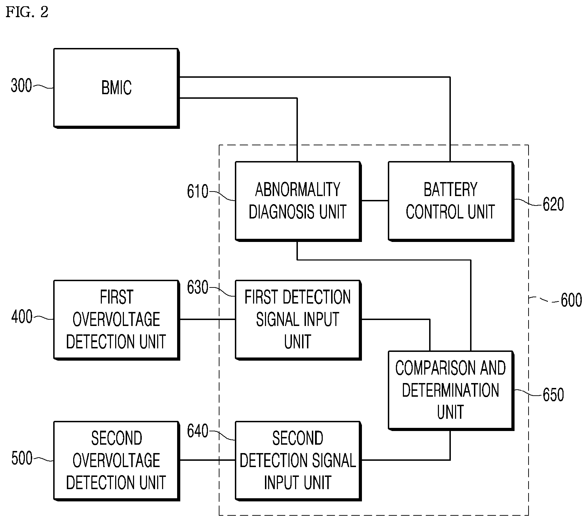

FIG. 1 is a block diagram for illustrating a configuration of a battery apparatus according to an embodiment of the present invention. That is, FIG. 1 is a block diagram of the battery apparatus including a battery and a battery management system. FIG. 2 is a block diagram for illustrating a configuration of an MCU of the battery management system according to an embodiment of the present invention.

Referring to FIG. 1, the battery apparatus according to an embodiment of the present invention includes a battery 100 including a plurality of battery cells capable of being charged and discharged, a monitoring unit 200 that monitors a state of the battery 100, a battery monitoring IC (BMIC) 300 that diagnoses the state of the battery 100 according to a monitoring result of the battery 100, a first overvoltage detection unit 400 that has a first reference voltage and compares a voltage of the battery 100 from the monitoring unit 200 with the first reference voltage, a second overvoltage detection unit 500 that has a second reference voltage different from the first reference voltage and compares the voltage of the battery 100 from the monitoring unit 200 with the second reference voltage, and an MCU 600 that exchanges signals through communication with the BMIC 300 and receives detection signals from the first and second overvoltage detection units 400 and 500 to control the battery 100 according to the state of the battery 100. Here, the monitoring unit 200, the BMIC 300, the first and second overvoltage detection units 400 and 500, and the MCU 600 form the battery management apparatus. The battery apparatus including the battery and the battery management system according to the present invention will be described in more detail for each component as follows.

### 1. Battery

The battery 100 is an electrical energy source that supplies energy to a power consuming device to drive the power consuming device. Here, the power consuming device may include a mobile device such as a smart phone and a transportation means such as an electric scooter, an electric vehicle, or a hybrid electric vehicle. The battery 100 may include at least one battery pack. In this case, each of the at least one battery pack may include a plurality of battery modules, and each of the battery modules may include a plurality of battery cells capable of being charged and discharged. That is, the battery 100 includes the plurality of battery cells, and the plurality of battery cells may be bundled in a predetermined unit to form the battery module, or the plurality of battery modules may form one battery pack. Meanwhile, the plurality of battery cells may be connected in series and/or in parallel in various ways to meet specifications of the power consuming device. Of course, a plurality of battery packs each including a plurality of battery cells may also be connected in series and/or in parallel. Here, the type of battery cell is not particularly limited, and may include, for example, a lithium ion battery, a lithium polymer battery, a nickel cadmium battery, a nickel hydride battery, a nickel zinc battery, etc.

### 2. Monitoring unit

The monitoring unit 200 may be provided to monitor a state of the battery 100. For example, the monitoring unit 200 may measure the current, voltage, temperature, etc. of the battery 100. In addition, the monitoring unit 200 may measure states of the battery pack, battery module, and battery cell. That is, the monitoring unit 200 may measure a state of each of the plurality of battery cells, a state of the battery module in which the plurality of battery cells are bundled, or a state of the battery pack in which the plurality of battery modules are bundled. To this end, the monitoring unit 200 may include a plurality of sensors. That is, the monitoring unit 200 may include at least one current sensor, at least one voltage sensor, and at least one temperature sensor. The current sensor, voltage sensor, and temperature sensor may periodically measure the current, voltage, and temperature of the battery 100 and provide the measurement results to the BMIC 300. The measurement result may be provided to the BMIC 300 as an analog signal or a digital signal. Here, the current sensor may generate a signal corresponding to the magnitude of a charging current. Of course, the current sensor can measure not only the magnitude of the charging current but also the magnitude of the discharging current. To this end, the current sensor may be installed on a charge/discharge path, which is a path through which the charging/discharging current flows in the battery 100, for example. Meanwhile, the current sensor according to the present invention may include a shunt resistor. In addition, the voltage sensor generates a signal corresponding to the voltage applied between a positive electrode and a negative electrode of the battery 100. As an example, the voltage sensor may include a differential amplifier circuit outputting a voltage signal corresponding to a voltage difference between the positive and negative terminals of the battery 100. Also, the temperature sensor may be, for example, a thermal coupler used for temperature measurement. The temperature sensor generates a signal corresponding to the temperature of the battery 100. In addition, the temperature sensor may further include an external temperature sensor for measuring an external temperature where heat from the battery 100 is dissipated, in addition to the temperature sensor for measuring the temperature of the battery 100. The external temperature sensor may be configured with the same type of sensor as the temperature sensor, and generates a signal corresponding to the external temperature. Meanwhile, the monitoring unit 200 may be connected to first and second overvoltage detection units 400 and 500 to provide voltage measurement results to the first and second overvoltage detection units 400 and 500. That is, the voltage of the battery 100 measured by the voltage sensor is provided to the first and second overvoltage detection units 400 and 500, and may be used for overvoltage detection by the first and second overvoltage detection units 400 and 500.

### 3. BMIC

The BMIC 300 receives a state signal of the battery measured by the monitoring unit 200, generates a diagnosis signal from measured status information, and transmits the diagnosis signal to the MCU 600. For example, the BMIC 300 may compare the battery voltage measured by the monitoring unit 200 with a set voltage range and generate the diagnosis signal according to the comparison result. As a specific example, when the battery voltage is set to 3 V to 4.5 V, the BMIC 300 may compare the battery voltage with the set voltage range, generate a diagnosis signal of a different level in the case of an abnormal voltage outside the set voltage range and in the case of a normal voltage, and transmit the diagnosis signal to the MCU 600. Even in the case of the current, it is possible to determine an abnormal current by determining whether the current is within or out of a set current range and generate a diagnosis signal according to the determination. The BMIC 300 and the MCU 600 may be connected through a predetermined communication line. Accordingly, the diagnosis signal may be transmitted from an output terminal of the BMIC 300 to an input terminal of the MCU 600 through the communication line. Meanwhile, the BMIC 300 may control the battery 100 according to a control signal transmitted from the MCU 600. For example, the BMIC 300 may discharge a cell to be balanced among a plurality of battery cells through a cell balancing circuit according to a cell balancing signal transmitted from the MCU 600. To this end, the BMIC 300 may generate a plurality of switching signals according to the cell balancing signal of the MCU 600. In this case, switches may be connected to the plurality of battery cells, and each switching signal may control a switching operation of a corresponding switch. When an on-level switching signal is supplied to a corresponding switch, the switch is turned on to discharge the corresponding battery cell. In this way, the BMIC 300 and the MCU 600 may be connected through a communication line in order to input/output predetermined data or a signal. That is, a communication unit including an output unit for outputting a state signal such as the diagnosis signal to the MCU 600 through the communication line and an input unit for receiving the signal such as the cell balancing signal from the BMIC 300 through the communication line of the BMIC 300 may be provided.

### 4. First overvoltage detection unit

The first overvoltage detection unit 400 is connected to the monitoring unit 200 and receives a voltage measurement value of the battery 100 from the monitoring unit 200. That is, the first overvoltage detection unit 400 receives the voltage measurement value of the battery 100 from the voltage sensor of the monitoring unit 200. The first overvoltage detection unit 400 has a first reference voltage and compares the voltage of the battery 100 with the first reference voltage. Here, the first reference voltage of the first overvoltage detection unit 400 may be set to a fault level lower than the second reference voltage of the second overvoltage detection unit 500. Accordingly, the first overvoltage detection unit 400 serves to verify whether the second overvoltage detection unit 500 has detected the voltage of the battery 100 in a normal state. Meanwhile, the first overvoltage detection unit 400 outputs first detection signals having different levels according to a comparison result between the first reference voltage and the voltage of the battery 100. For example, the first overvoltage detection unit 400 outputs a first detection signal of a low level when the voltage of the battery 100 is lower than the first reference voltage, and outputs a first detection signal of a high level when the voltage of the battery 100 is higher than the first reference voltage. The first detection signal from the first overvoltage detection unit 400 is transmitted to the MCU 600. The first overvoltage detection unit 400 may be provided in preparation for a case in which overvoltage detection is impossible due to a diagnosis error of the BMIC 300.

### 5. Second overvoltage detection unit

The second overvoltage detection unit 500 is connected to the monitoring unit 200 and receives the voltage measurement value of the battery 100 from the monitoring unit 200. That is, the second overvoltage detection unit 500 receives the voltage measurement value of the battery 100 from the voltage sensor of the monitoring unit 200 simultaneously with the first overvoltage detection unit 400. The second over-voltage detection unit 500 has a second reference voltage and compares the voltage of the battery 100 with the second reference voltage. Here, the second reference voltage of the second overvoltage detection unit 500 may be set to a fail level greater than the first reference voltage of the first overvoltage detection unit 400. That is, the second overvoltage detection unit 500 has a reference voltage for actually entering a safe state. Meanwhile, the second overvoltage detection unit 500 outputs second detection signals having different levels according to a comparison result between the second reference voltage and the voltage of the battery 100. For example, the second overvoltage detection unit 500 outputs the second detection signal of a low level when the voltage of the battery 100 is lower than the second reference voltage, and outputs the second detection signal of a high level when the voltage of the battery 100 is higher than the second reference voltage. The second detection signal from the second overvoltage detection unit 500 is transmitted to the MCU 600. The second overvoltage detection unit 500 may be provided together with the first overvoltage detection unit 400 according to the present invention in preparation for a case where overvoltage detection is impossible due to a diagnosis error of the BMIC 300.

### 6. MCU

The MCU 600 may receive the diagnosis signal from the BMIC 300, monitor the state of the battery 100, and control the battery 100 according to the state of the battery 100. For example, when an abnormality diagnosis signal of a battery voltage or current is input from the BMIC 300, the MCU 600 may stop the operation of the battery using functions such as communication off. To this end, the MCU 600 may include an abnormality diagnosis unit 610. That is, the abnormality diagnosis unit 610 of the MCU 600 may stop the operation of the battery 100 according to the abnormality diagnosis signal generated when the voltage of the battery 100 is out of the set voltage range or the current of the battery 100 is out of the set current range. In addition, the MCU 600 may control battery operations such as charging/discharging of the battery or cell balancing according to the diagnosis signal of the BMIC 300. To this end, the MCU 600 may include a battery control unit 620. That is, when the voltage of the battery is within the set voltage range or the current of the battery is within the set current range, the battery control unit 620 of the MCU 600 may stop the operation of the battery according to a normality diagnosis signal. In this case, the MCU 600 may control charging of the battery through the battery control unit 620 when the voltage or current of the battery is low, and may control discharging of the battery when the voltage or current is stable. In addition, the MCU 600 may control cell balancing through the battery control unit 620 when at least one battery cell is higher than a set voltage or current. For cell balancing, the MCU 600 may control cell balancing through the BMIC 300 by outputting a balancing control signal to the BMIC 300. For this operation, the MCU 600 may be connected to the BMIC 300 through a predetermined communication line. That is, the MCU 600 may be provided with a communication unit including an input unit for receiving the state signal such as the diagnosis signal from the BMIC 300 through the communication line and an output unit TX for outputting the signal such as the cell balancing signal to the BMIC 300 through the communication line.

In addition, the MCU 600 according to the present invention receives the first and second detection signals from the first and second overvoltage detection units 400 and 500 as well as the voltage of the battery 100 diagnosed from the BMIC 300. That is, the MCU 600 may include first and second detection signal input units 630 and 640 for receiving the first and second detection signals from the first and second overvoltage detection units 400 and 500, respectively. The MCU 600 may diagnose abnormalities in the BMIC 300, the first and second overvoltage detection units 400 and 500, and a peripheral circuit thereof by using the first and second detection signals. To this end, the MCU 600 may include a comparison and determination unit 650. When the first and second detection signals from the first and second overvoltage detection units 400 and 500 are input, the comparison and determination unit 650 may diagnose abnormalities in the BMIC 300, the first and second overvoltage detection units 400 and 500, and the peripheral circuit thereof by comparing the first and second reference voltages of the first and second overvoltage detection units 400 and 500 with the battery voltage. That is, when the second detection signal is generated from the second overvoltage detection unit 500, that is, when the second detection signal is input at a high level, the MCU 600 may diagnose a measurement error of the BMIC 300 or the MCU 600 by comparing the voltage of the battery 100 input from the BMIC 300 through the abnormality diagnosis unit 610 with the second reference voltage of the second overvoltage detection unit 500. In addition, when the second detection signal is input from the second overvoltage detection unit 500 at a high level, the MCU 600 may diagnose an error of at least one of the first and second overvoltage detection units 400 and 500 according to the first detection signal from the first overvoltage detection unit 400. That is, the MCU 600 determines that the BMIC 300, the first and second overvoltage detection units 400 and 500, and the MCU 600 and the peripheral circuit thereof operate normally when the second detection signal is not generated, that is, when the second detection signal is input at a low level, and performs a diagnosis operation when the second detection signal is input at a high level. A driving method according to a diagnosis operation of the MCU 600 will be described in more detail. When the second detection signal from the second overvoltage detection unit 500 is input at a high level, the MCU 600 compares the maximum voltage (cell max voltage) of the battery 100 from the BMIC 300 with the second reference voltage of the second overvoltage detection unit 500. When the maximum voltage of the battery 100 is higher than the second reference voltage, it is determined that the second overvoltage detection unit 500 has operated normally. However, when the second detection signal from the second overvoltage detection unit 500 is input at a high level and the maximum voltage of the battery 100 is lower than the second reference voltage, the MCU 600 determines that a voltage measurement error for the battery 100 or an abnormality of the second overvoltage detection unit 500 occurs. That is, if the maximum voltage of the battery 100 from the BMIC 300 is lower than the second reference voltage of the second overvoltage detection unit 500, it may be determined that the battery voltage is incorrectly measured due to an error in the BMIC 300 or MCU 600, or the second detection signal is incorrectly output from the second overvoltage detection unit 500 due to an abnormality of the second overvoltage detection unit or the peripheral circuit thereof.

In addition, when the second detection signal is input from the second overvoltage detection unit 500 at a high level and the first detection signal is input from the first overvoltage detection unit 400 at a high level, since the first reference voltage is lower than the second reference voltage, the MCU 600 may determine that the second overvoltage detection unit 500 operates normally. However, when the second detection signal is input from the second overvoltage detection unit 500 at the high level and the first detection signal is input from the first overvoltage detection unit 400 at the low level, it may be determined that at least one of the first and second overvoltage detection units 400 and 500 has operated abnormally. That is, it can be determined that an abnormality of the overvoltage detection unit occurs.

As described above, the battery apparatus according to an embodiment of the present invention includes first and second overvoltage detection units 400 and 500 between the BMCI 300 and the MCU 600. That is, in the present invention, one more overvoltage detection unit is provided compared to the prior art. Here, the first and second overvoltage detection units 400 and 500 have different first and second reference voltages, and the first reference voltage has a lower value than the second reference voltage. The first and second overvoltage detection units 400 and 500 compare the voltage of the battery 100 measured by the monitoring unit 200 with the first and second reference voltages, respectively, and output first and second detection signals, respectively. When the battery voltage is greater than the first and second reference voltages, the first and second overvoltage detection units 400 and 500 generate first and second detection signals, respectively, and supply the first and second detection signals to the MCU 600. The MCU 600 may diagnose abnormalities in the BMIC 300, the first and second overvoltage detection units 400 and 500, and the peripheral circuit thereof by using the first and second detection signals. That is, when the second detection signal is generated from the second overvoltage detection unit 500, the MCU 600 may diagnose a measurement error of the BMIC 300 or the MCU 600 by comparing the voltage of the battery 100 input from the BMIC and the second reference voltage of the second overvoltage detection unit 500. In addition, when the second detection signal is input from the second overvoltage detection unit 500 at a high level, the MCU 600 may diagnose an error of at least one of the first and second overvoltage detection units 400 and 500 according to the first detection signal from the first overvoltage detection unit 400. That is, if the second detection signal is not generated, that is, if the second detection signal is input at a low level, the MCU 600 determines that the BMIC 300, the first overvoltage detection unit 400 and 500, and the peripheral circuit thereof operate normally, and if the second detection signal is input at a high level, the MCU 600 performs the diagnosis operation.

Therefore, compared to the prior art, the present invention can prevent an erroneous detection problem due to the failure of the overvoltage detection unit or the failure of the peripheral circuit around the overvoltage detection unit. That is, by using two overvoltage detection units having different reference voltages, it is possible to prevent a problem in which the overvoltage detection unit fails to properly detect an overvoltage due to the failure of the overvoltage detection unit itself or the failure of a circuit around the overvoltage detection unit.

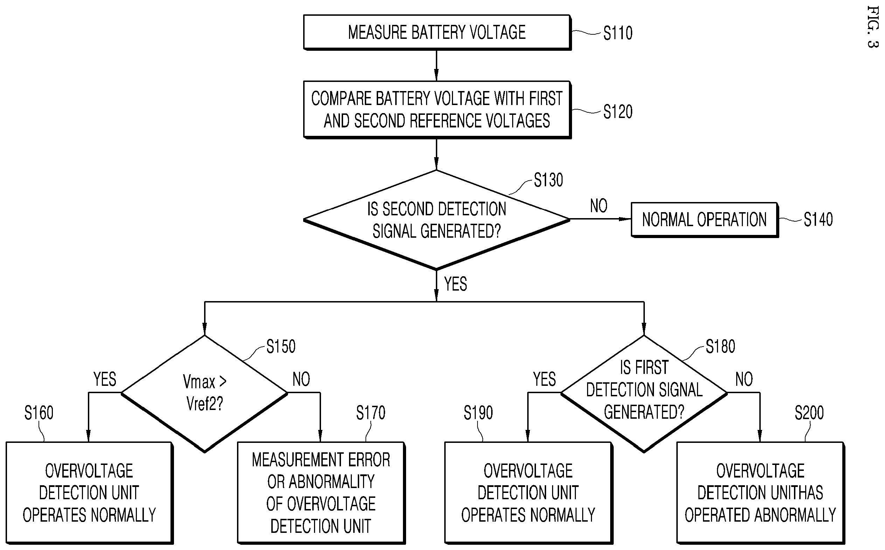

FIG. 3 is a flowchart illustrating a method of operating the battery apparatus according to an embodiment of the present invention.

Referring to FIG. 3, the method includes a process of measuring a state of the battery 100 S110, a process of comparing a voltage measurement value of the battery 100 with first and second reference voltages Vref1 and Vref2 S120, a process of determining whether a second detection signal is generated because the second reference voltage Vref2 is higher than the voltage measurement value S130, a process of determining that the operation is normal if the second detection signal is not generated S140, a process of comparing the maximum voltage Vmax of the battery 100 and the second reference voltage Vref2 if the second detection signal is generated S150, a process of determining that the second overvoltage detection unit 500 operates normally if the maximum voltage Vmax of the battery 100 is higher than the second reference voltage Vref2 S160, a process of determining that a voltage measurement error of the battery 100 or an abnormality of the second overvoltage detection unit 500 occurs if the maximum voltage of the battery 100 is lower than the second reference voltage S170, a process of determining whether the second detection signal is generated and the first detection signal is generated S180, a process of determining that the second overvoltage detection unit 500 operates normally if the first detection signal is generated S190, and a process of determining that at least one of the first and second overvoltage detection units has operated abnormally if the first detection signal is not generated S200. Here, S150 and S180 may be performed simultaneously or sequentially. When performed sequentially, S150 may be performed first and S180 may be performed later, and conversely, S180 may be performed first and then S150 may be performed.

The method of operating the battery apparatus according to an embodiment of the present invention will be described in more detail for each process as follows.

S110: The monitoring unit 200 monitors the state of the battery 100. For example, the monitoring unit 200 may measure the current, voltage, temperature, etc. of the battery 100. In this case, the monitoring unit 200 may measure the states of the battery pack, battery module, and battery cell. To this end, the monitoring unit 200 may include at least one current sensor, at least one voltage sensor, and at least one temperature sensor. The current sensor, voltage sensor, and temperature sensor may periodically measure the current, voltage, and temperature of the battery 100 and provide the measurement results to the BMIC 300. Here, the current sensor may generate a signal corresponding to the magnitude of the charging current. Of course, the current sensor may measure the magnitude of the discharge current as well as the magnitude of the charging current. In addition, the voltage sensor generates a signal corresponding to the voltage applied between the positive electrode and the negative electrode of the battery 100. As an example, the voltage sensor may include a differential amplifier circuit outputting a voltage signal corresponding to a voltage difference between the positive and negative terminals of the battery 100. In addition, the temperature sensor may be, for example, a thermal coupler used for temperature measurement. The temperature sensor generates a signal corresponding to the temperature of the battery 100. In addition, the monitoring unit 200 may be connected to the first and second overvoltage detection units 400 and 500 to provide voltage measurement results to the first and second overvoltage detection units 400 and 500. That is, the voltage of the battery 100 measured by the voltage sensor is provided to the first and second overvoltage detection units 400 and 500, and may be used for overvoltage detection by the first and second overvoltage detection units 400 and 500.

Meanwhile, the BMIC 300 receives the battery state signal measured by the monitoring unit 200, generates a diagnosis signal from measured state information, and transmits the measured state information to the MCU 600. For example, the BMIC 300 may compare the battery voltage measured by the monitoring unit 200 with a set voltage range and generate the diagnosis signal according to the comparison result. As a specific example, when the battery voltage is set to 3V to 4.5V, the BMIC 300 may compare the battery voltage with the set voltage range, generate a diagnosis signal of a different level in the case of an abnormal voltage outside the set voltage range and in the case of a normal voltage, and transmit the diagnosis signal to the MCU 600. Even in the case of the current, it is possible to determine an abnormal current by determining whether the current is within or out of a set current range and generate a diagnosis signal according to the determination. The BMIC 300 and the MCU 600 may be connected through a predetermined communication line. Accordingly, the diagnosis signal may be transmitted from an output terminal of the BMIC 300 to an input terminal of the MCU 600 through the communication line.

S120: The voltage measurement value of the battery 100 by the monitoring unit 200 is compared with the first and second reference voltages Vref1 and Vref2 of the first and second overvoltage detection units 400 and 500, respectively. To this end, the first and second overvoltage detection units 400, 500 have the first and second reference voltages Vref1 and Vref2, respectively, and receive the voltage measurement value of the battery 100 from the monitoring unit 200, respectively. Also, the first and second overvoltage detection units 400 and 500 compare the voltage of the battery 100 with the first and second reference voltages, respectively. Here, the first reference voltage of the first overvoltage detection unit 400 may be set to a fault level lower than the second reference voltage of the second overvoltage detection unit 500, and the second reference voltage may be set to a fail level higher than the first reference voltage. Meanwhile, the first and second overvoltage detection units 400 and 500 respectively output first and second detection signals having different levels according to a comparison result between the first and second reference voltages and the voltage of battery 100. For example, the first overvoltage detection unit 400 outputs a first detection signal of a low level if the voltage of the battery 100 is lower than the first reference voltage, and outputs a first detection signal of a high level if the voltage of the battery 100 is higher than the first reference voltage. For example, the second overvoltage detection unit 500 outputs the second detection signal of a low level if the voltage of the battery 100 is lower than the second reference voltage, and outputs the second detection signal of a high level if the voltage of the battery 100 is higher than the second reference voltage. That is, the first and second overvoltage detection units 400 and 500 respectively generate first and second detection signals if the battery voltage is higher than the first and second reference voltages. The first and second detection signals from the first and second overvoltage detection units 400 and 500 are transmitted to the MCU 600, respectively.

S130: The MCU 600 determines whether the second detection signal is input from the second overvoltage detection unit 500. That is, if the second overvoltage detection unit 500 generates the second detection signal at a high level because the voltage of the battery 100 is higher than the second reference voltage and outputs the second detection signal to the MCU 600, the MCU 600 determines whether the second detection signal is input at a high level.

S140: If the second detection signal is not input from the second overvoltage detection unit 500, that is, if the second detection signal of low level is input because the voltage of the battery 100 is lower than the second reference voltage, the MCU 600 determines that the operation is normal. That is, in this case, the MCU 600 may determine that the BMIC 300, the first and second overvoltage detection units 400 and 500, the MCU 600, and a peripheral circuit thereof operate normally.

S150: If it is determined that the second detection signal is input from the second overvoltage detection unit 500, the MCU 600 compares the maximum voltage Vmax of the battery 100 from the BMIC 300 with the second reference voltage Vref2 of the second overvoltage detection unit 500.

S160: If the maximum voltage of the battery 100 is higher than the second reference voltage, it is determined that the second overvoltage detection unit 500 operates normally.

S170: By the way, if the second detection signal from the second overvoltage detection unit 500 is input at a high level and the maximum voltage of the battery 100 is lower than the second reference voltage, the MCU 600 may determine that a voltage measurement error of the battery 100 or an abnormality of the second overvoltage detection unit 500 occurs. That is, if the maximum voltage of the battery 100 from the BMIC 300 is lower than the second reference voltage, it may be determined that the battery voltage is incorrectly measured due to an error in the BMIC 300 or MCU 600, or the second detection signal is incorrectly output from the second overvoltage detection unit 500 due to an abnormality of the second overvoltage detection unit or the peripheral circuit thereof.

S180: In addition, the MCU 600 determines whether the second detection signal is input from the second overvoltage detection unit 500 at a high level and the first detection signal is input from the first overvoltage detection unit 400 at a high level.

S190: When the first detection signal is input at a high level simultaneously with the second detection signal, it may be determined that the second overvoltage detection unit 500 operates normally.

S200: However, when the second detection signal is input from the second overvoltage detection unit 500 at a high level and the first detection signal is input from the first overvoltage detection unit 400 at a low level, it may be determined that at least one of the first and second overvoltage detection units 400 and 500 has operated abnormally. That is, it may be determined that an abnormality of the overvoltage detection unit occurs.

The names of the reference numerals of respective parts used in the invention are as follows.
100: battery
200: monitoring unit
300: BMIC
400: First overvoltage detection unit
500: Second overvoltage detection unit
600: MCU

## Claims

1. A battery management system comprising:
a battery monitoring integrated circuit, BMIC, (300) that diagnoses a state of a battery (100);
a first overvoltage detection unit (400) that generates a first detection signal by comparing a battery voltage of the battery with a first reference voltage (Vref1);
a second overvoltage detection unit (500) that generates a second detection signal by comparing the battery voltage with a second reference voltage (Vref2) different from the first reference voltage (Vref1); and
a micro controller unit, MCU, (600) that controls the battery (100) according to a diagnosis signal from the BMIC (300) and diagnoses an abnormality of an apparatus according to the first and second detection signals;
wherein the first reference voltage (Vref1) is lower than the second reference voltage (Vref2);
**characterized in that** the MCU (600) is configured to:
determine that the second overvoltage detection unit (500) has operated normally if a maximum voltage of the battery (100) is higher than the second reference voltage (Vref2) when the second detection signal is generated; and
determine that a voltage measurement error for the battery (100) or an abnormality of the second overvoltage detection unit (500) occurs if the maximum voltage of the battery (100) is lower than the second reference voltage (Vref2) when the second detection signal is generated.

2. The battery management system of claim 1, wherein
the first overvoltage detection unit (400) generates the first detection signal if the battery voltage is higher than the first reference voltage (Vref1), and
the second overvoltage detection unit (500) generates the second detection signal if the battery voltage is higher than the second reference voltage (Vref2).

3. The battery management system of claim 2, wherein
if the second detection signal is not generated, the MCU (600) determines that the BMIC (300), the first (400) and second (500) overvoltage detection units, and a peripheral circuit thereof operate normally.

4. The battery management system of claim 2, wherein
when the second detection signal is generated, the MCU (600) determines an error of at least one of the first overvoltage detection unit (400) and the second overvoltage detection unit (500) according to the first detection signal.

5. The battery management system of claim 4, wherein
if the second detection signal is generated and the first detection signal is generated, it is determined that the second overvoltage detection unit (500) operates normally.

6. The battery management system of claim 5, wherein
if the second detection signal is generated and the first detection signal is not generated, it is determined that at least one of the first overvoltage detection unit (400) and the second overvoltage detection unit (500) has operated abnormally.

7. A battery management method comprising:
a process of measuring (S110) a state of a battery (100);
a process of comparing (S120) a voltage measurement value of the battery (100) with a first reference voltage (Vref1) of a first overvoltage detection unit (400) and a second reference voltage (Vref2) of a second overvoltage detection unit (500), respectively, wherein the first reference voltage (V_{ref1}) is lower than the second reference voltage (V_{ref2});
a process of determining (S130) whether a second detection signal is generated from the second overvoltage detection unit (500) because the second reference voltage (Vref2) is higher than the measured battery voltage (100);
a process of determining (S140) that an operation of the battery (100) is normal if the second detection signal is not generated;
a process of comparing (S150) a maximum voltage of the battery (100) and the second reference voltage (Vref2) if the second detection signal is generated;
a process of determining (S160) that the second overvoltage detection unit (500) has operated normally if the maximum voltage of the battery (100) is higher than the second reference voltage (Vref2); and
a process of determining (S170) that a voltage measurement error for the battery (100) or an abnormality of the second overvoltage detection unit (500) occurs if the maximum voltage of the battery (100) is lower than the second reference voltage (Vref2).

8. The battery management method of claim 7 or 8, further comprising:
a process of determining (S180) whether the second detection signal is generated and the first detection signal is generated;
a process of determining (S190) that the second overvoltage detection unit (500) operates normally if the first detection signal is generated; and
a process of determining (S200) that at least one of the first and second overvoltage detection units has operated abnormally if the first detection signal is not generated.

## Patentansprüche

1. Batteriemanagementsystem, umfassend:
eine integrierte Schaltung zur Batterieüberwachung, BMIC, (300), die einen Zustand einer Batterie (100) diagnostiziert;
eine erste Überspannungserfassungseinheit (400), die ein erstes Erfassungssignal erzeugt, indem sie eine Batteriespannung der Batterie mit einer ersten Referenzspannung (V_{ref1}) vergleicht;
eine zweite Überspannungserfassungseinheit (500), die ein zweites Erfassungssignal erzeugt, indem sie die Batteriespannung mit einer zweiten Referenzspannung (V_{ref2}) vergleicht, die sich von der ersten Referenzspannung (V_{ref1}) unterscheidet; und
eine Mikrocontrollereinheit, MCU, (600), die die Batterie (100) gemäß einem Diagnosesignal von der BMIC (300) steuert und eine Anomalie einer Vorrichtung gemäß dem ersten und zweiten Erfassungssignal diagnostiziert;
wobei die erste Referenzspannung (V_{ref1}) niedriger ist als die zweite Referenzspannung (V_{ref2});
**dadurch gekennzeichnet, dass** die MCU (600) für Folgendes konfiguriert ist:
Bestimmen, dass die zweite Überspannungserfassungseinheit (500) normal gearbeitet hat, wenn eine maximale Spannung der Batterie (100) höher ist als die zweite Referenzspannung (V_{ref2}), wenn das zweite Erfassungssignal erzeugt wird; und
Bestimmen, dass ein Spannungsmessfehler für die Batterie (100) oder eine Anomalie der zweiten Überspannungserfassungseinheit (500) auftritt, wenn die maximale Spannung der Batterie (100) niedriger ist als die zweite Referenzspannung (V_{ref2}), wenn das zweite Erfassungssignal erzeugt wird.

2. Batteriemanagementsystem nach Anspruch 1, wobei
die erste Überspannungserfassungseinheit (400) das erste Erfassungssignal erzeugt, wenn die Batteriespannung höher ist als die erste Referenzspannung (V_{ref1}), und
die zweite Überspannungserfassungseinheit (500) das zweite Erfassungssignal erzeugt, wenn die Batteriespannung höher ist als die zweite Referenzspannung (V_{ref2}).

3. Batteriemanagementsystem nach Anspruch 2, wobei,
wenn das zweite Erfassungssignal nicht erzeugt wird, die MCU (600) bestimmt, dass die BMIC (300), die erste (400) und die zweite (500) Überspannungserfassungseinheit und eine periphere Schaltung davon normal arbeiten.

4. Batteriemanagementsystem nach Anspruch 2, wobei,
wenn das zweite Erfassungssignal erzeugt wird, die MCU (600) einen Fehler von mindestens einer der ersten Überspannungserfassungseinheit (400) und der zweiten Überspannungserfassungseinheit (500) gemäß dem ersten Erfassungssignal bestimmt.

5. Batteriemanagementsystem nach Anspruch 4, wobei,
wenn das zweite Erfassungssignal erzeugt wird und das erste Erfassungssignal erzeugt wird, bestimmt wird, dass die zweite Überspannungserfassungseinheit (500) normal arbeitet.

6. Batteriemanagementsystem nach Anspruch 5, wobei,
wenn das zweite Erfassungssignal erzeugt wird und das erste Erfassungssignal nicht erzeugt wird, bestimmt wird, dass mindestens eine der ersten Überspannungserfassungseinheit (400) und der zweiten Überspannungserfassungseinheit (500) anomal gearbeitet hat.

7. Batteriemanagementverfahren, umfassend:
einen Prozess des Messens (S110) eines Zustands einer Batterie (100);
einen Prozess des Vergleichens (S120) eines Spannungsmesswerts der Batterie (100) mit einer ersten Referenzspannung (V_{ref1}) einer ersten Überspannungserfassungseinheit (400) bzw. einer zweiten Referenzspannung (V_{ref2}) einer zweiten Überspannungserfassungseinheit (500), wobei die erste Referenzspannung (V_{ref1}) niedriger ist als die zweite Referenzspannung (V_{ref2});
einen Prozess des Bestimmens (S130), ob ein zweites Erfassungssignal von der zweiten Überspannungserfassungseinheit (500) erzeugt wird, weil die zweite Referenzspannung (V_{ref2}) höher ist als die gemessene Batteriespannung (100);
einen Prozess des Bestimmens (S140), dass ein Betrieb der Batterie (100) normal ist, wenn das zweite Erfassungssignal nicht erzeugt wird;
einen Prozess des Vergleichens (S150) einer maximalen Spannung der Batterie (100) und der zweiten Referenzspannung (V_{ref2}), wenn das zweite Erfassungssignal erzeugt wird;
einen Prozess des Bestimmens (S160), dass die zweite Überspannungserfassungseinheit (500) normal gearbeitet hat, wenn die maximale Spannung der Batterie (100) höher ist als die zweite Referenzspannung (V_{ref2}); und
einen Prozess des Bestimmens (S170), dass ein Spannungsmessfehler für die Batterie (100) oder eine Anomalie der zweiten Überspannungserfassungseinheit (500) auftritt, wenn die maximale Spannung der Batterie (100) niedriger ist als die zweite Referenzspannung (V_{ref2}).

8. Batteriemanagementverfahren nach Anspruch 7 oder 8, ferner umfassend:
einen Prozess des Bestimmens (S180), ob das zweite Erfassungssignal erzeugt wird und das erste Erfassungssignal erzeugt wird;
einen Prozess des Bestimmens (S190), dass die zweite Überspannungserfassungseinheit (500) normal arbeitet, wenn das erste Erfassungssignal erzeugt wird; und
einen Prozess des Bestimmens (S200), dass mindestens eine der ersten und der zweiten Überspannungserfassungseinheit anomal gearbeitet hat, wenn das erste Erfassungssignal nicht erzeugt wird.

## Revendications

1. Un système de gestion de batterie comprenant :
un circuit intégré de surveillance de batterie, BMIC, (300) qui diagnostique un état d'une batterie (100) ;
une première unité de détection de surtension (400) qui génère un premier signal de détection en comparant une tension de batterie de la batterie à une première tension de référence (V_{ref1}) ;
une seconde unité de détection de surtension (500) qui génère un second signal de détection en comparant la tension de batterie à une seconde tension de référence (V_{ref2}) différente de la première tension de référence (V_{ref1}) ; et
une unité de microcontrôleur, MCU, (600) qui commande la batterie (100) selon un signal de diagnostic provenant du BMIC (300) et diagnostique une anomalie d'un appareil selon les premier et second signaux de détection ;
dans lequel la première tension de référence (V_{ref1}) est inférieure à la seconde tension de référence (V_{ref2}) ;
**caractérisé en ce que** la MCU (600) est configurée pour :
déterminer que la seconde unité de détection de surtension (500) a fonctionné normalement si une tension maximale de la batterie (100) est supérieure à la seconde tension de référence (V_{ref2}) lorsque le second signal de détection est généré ; et
déterminer qu'une erreur de mesure de tension pour la batterie (100) ou une anomalie de la seconde unité de détection de surtension (500) se produit si la tension maximale de la batterie (100) est inférieure à la seconde tension de référence (V_{ref2}) lorsque le second signal de détection est généré.

2. Le système de gestion de batterie selon la revendication 1, dans lequel
la première unité de détection de surtension (400) génère le premier signal de détection si la tension de batterie est supérieure à la première tension de référence (V_{ref1}), et
la seconde unité de détection de surtension (500) génère le second signal de détection si la tension de batterie est supérieure à la seconde tension de référence (V_{ref2}).

3. Le système de gestion de batterie selon la revendication 2, dans lequel
si le second signal de détection n'est pas généré, la MCU (600) détermine que le BMIC (300), les première (400) et seconde (500) unités de détection de surtension, et un circuit périphérique de celles-ci fonctionnent normalement.

4. Le système de gestion de batterie selon la revendication 2, dans lequel
lorsque le second signal de détection est généré, la MCU (600) détermine une erreur d'au moins l'une de la première unité de détection de surtension (400) et de la seconde unité de détection de surtension (500) selon le premier signal de détection.

5. Le système de gestion de batterie selon la revendication 4, dans lequel
si le second signal de détection est généré et le premier signal de détection est généré, il est déterminé que la seconde unité de détection de surtension (500) fonctionne normalement.

6. Le système de gestion de batterie selon la revendication 5, dans lequel
si le second signal de détection est généré et que le premier signal de détection n'est pas généré, il est déterminé qu'au moins l'une de la première unité de détection de surtension (400) et de la seconde unité de détection de surtension (500) a fonctionné anormalement.

7. Un procédé de gestion de batterie comprenant :
un processus de mesure (S110) d'un état d'une batterie (100) ;
un processus de comparaison (S120) d'une valeur de mesure de tension de la batterie (100) avec une première tension de référence (V_{ref1}) d'une première unité de détection de surtension (400) et une seconde tension de référence (V_{ref2}) d'une seconde unité de détection de surtension (500), respectivement, dans lequel la première tension de référence (V_{ref1}) est inférieure à la seconde tension de référence (V_{ref2}) ;
un processus de détermination (S130) si un second signal de détection est généré par la seconde unité de détection de surtension (500) parce que la seconde tension de référence (V_{ref2}) est supérieure à la tension de batterie mesurée (100) ;
un processus de détermination (S140) qu'un fonctionnement de la batterie (100) est normal si le second signal de détection n'est pas généré ;
un processus de comparaison (S150) d'une tension maximale de la batterie (100) et de la seconde tension de référence (V_{ref2}) si le second signal de détection est généré ;
un processus de détermination (S160) que la seconde unité de détection de surtension (500) a fonctionné normalement si la tension maximale de la batterie (100) est supérieure à la seconde tension de référence (V_{ref2}) ; et
un processus de détermination (S170) qu'une erreur de mesure de tension pour la batterie (100) ou une anomalie de la seconde unité de détection de surtension (500) se produit si la tension maximale de la batterie (100) est inférieure à la seconde tension de référence (V_{ref2}).

8. Le procédé de gestion de batterie selon la revendication 7 ou 8, comprenant en outre :
un processus de détermination (S180) si le second signal de détection est généré et le premier signal de détection est généré ;
un processus de détermination (S190) que la seconde unité de détection de surtension (500) fonctionne normalement si le premier signal de détection est généré ; et
un processus de détermination (S200) qu'au moins l'une des première et seconde unités de détection de surtension a fonctionné anormalement si le premier signal de détection n'est pas généré.
